(19) **Europäisches Patentamt**

**European Patent Office**

**Office européen des brevets**

(11) **EP 1 017 179 A2**

(12) **EUROPEAN PATENT APPLICATION**

(43) Date of publication:
05.07.2000 Bulletin 2000/27

(51) Int. Cl.7: **H03M 13/35**

(21) Application number: **99126085.2**

(22) Date of filing: **28.12.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **28.12.1998 JP 37449798**

(71) Applicant: **NEC CORPORATION**
**Tokyo (JP)**

(72) Inventors:
- **Kanazawa, Akihiro,**
  **c/o NEC Corporation**
  **Tokyo (JP)**
- **Momona, Morihisa**
  **c/o NEC Corporation**
  **Minato-ku, Tokyo (JP)**

(74) Representative:
**von Samson-Himmelstjerna, Friedrich R., Dipl.-Phys. et al**
**SAMSON & PARTNER**
**Widenmayerstrasse 5**
**80538 München (DE)**

(54) **Error correcting encoder and error correcting decoder**

(57)    Error correcting decoder 10 to solve the problem in the selected drawing comprises the input selection circuit 200 and a plurality of the error correction decoding circuit 210, 220 and 230 to divide destination of an inputted signal according to encoding parameters, and the output selection circuit 250 to select the output of the error correction decoding circuit, input selection circuit 200, and control circuit 270 to control the operation of the output selection circuit 250.

FIG 1

EP 1 017 179 A2

Printed by Xerox (UK) Business Services
2.16.7 (HRS)/3.6

**Description**

Background of the Invention:

The present invention relates to an error correcting encoder and an error correcting decoder for correcting code error caused by transmission or accumulation of a digital code.

Conventionally, error correcting encoder and decoder for encoding or decoding of a block unit, of which encoding parameter is variable, changes a encoding parameter by changing computing method inside the encoder and the decoder. Therefore, changing the encoding parameter of error correcting encoder and decoder is possible with restriction to a period lacking data during processing inside the encoder and the decoder.

In data communications based on a variable length packet, usage efficiency of a line and noise tolerance are simultaneously increased by changing the parameter for error correction encoding according to the length of data frame. In order to realize such operation, information about frame length and the error correcting encoding parameter for use are previously adjusted in a transmission node and a receiving node and the error correcting encoding parameter may be changed according to the frame by changing the error correcting encoding parameter for every time of frame arrival.

However, it is restricted that the conventional error correcting encoder and the error correcting decoder, of which encoding parameters are variable, require a certain time for completion of encoding and decoding, and encoding parameters cannot be changed during the time. Therefore, performing error correction encoding processing and error correction decoding processing of a signal of which encoding parameters are frequently changed, particularly, performing error correction encoding processing and error correction decoding processing are difficult for a signal of which error correction encoding blocks of various encoding parameters arrive with very small time intervals.

Different error correcting encoding parameters generally causes a change of processing time for error correction encoding and error correction decoding. Therefore, An output generated from an input, which has a mixture of error correction encoding blocks of various encoding parameters, subjected to error correction encoding and error correction decoding has a problem such that an order of encoding blocks is incorrectly outputted and that times for outputting a certain encoding block and other encoding blocks therebefore and thereafter overlap to cause to generate an abnormal output.

Summary of the Invention:

It is therefore an object of the present invention to realize a function to perform error correction encoding and decoding processing of a signal of which encoding parameters change, particularly, a function to perform error correction encoding processing and error correction decoding processing of a signal of which error correction encoding blocks of various encoding parameters arrive with very small time intervals; conventionally, such function was difficult to realize.

Other objects of the present invention will become clear as the description proceeds.

The invention according to claim1, is characterized in that an error correcting decoder to decode with correcting an error of a datum subjected to error correction encoding in a block, wherein the error correcting decoder comprises: a plurality of an error correction decoding circuit performing error correction decoding processing for a block length of error correction encoding, or a length of redundant code, or such parameter for error correction encoding as a calculation formula for performing error correction encoding on the basis of the parameters different each other for error correction encoding, a selection circuit to select one, in which a block is inputted, of the block from the plurality of error correction decoding circuit on the basis of the encoding parameters of the block for each block of an inputted signal in the error correcting decoder, a multiplexing circuit to output a plurality signals, that is arrived from the plurality of error correction decoding circuit, outputted from the error correcting decoder by multiplexing in a single signal.

The invention according to claim2, is characterized in that the error correcting decoder according to claim 1 further comprising a delay circuit to add delay to an input signal arrived from the error correction decoding circuit or an input signal to the respective error correction decoding circuit, wherein in the delay circuit, a delaying amount is adjusted to be output a signal inputted to the respective the error correction decoding circuit from the error correction decoding circuit after the identical time, and the multiplexing circuit outputs a multiplexed signal in the same order as that of a block inputted in the error correction decoding circuit.

Specifically, if it is assumed that delay amounts designated by respective delay means are d1, d2, d3, ... and processing delay amounts in error correction decoding circuit making a pair with respective delay means are t1, t2, t3, ..., respectively,

the sum of all the delay amounts is set to make zero value as follows.

$$t1+d1=t0$$

$$t2+d2=t0$$

$$t3+d3=t0$$

The invention according to claim3, is characterized in that the error correcting decoder according to claim 1 comprising: a plurality of the first memory means to store temporality a signal outputted from plurality of an error correction decoding circuit, the second memory means to store an area of an error correction decoding circuit, in which the block of signals inputted in the error correction decoder has been inputted, a reading means to read a signal subjected to error correcting decoding from the plurality of the first memory means on the basis of memory stored in the second memory means in the same order as that of the block of the inputted signals inputted in the error correction decoder, wherein the multiplexing circuit outputs outputted signals from the plurality of the first memory means through multiplexing in a single signal them.

The invention according to claim4, is characterized in that an error correcting encoder comprising: an error correcting encoder to perform error correcting encoding for each block of a digital datum, wherein the error correcting encoder comprises a plurality of an error correction encoding circuit performing error correction encoding processing for a block length of error correction encoding, or a length of redundant code, or such parameter for error correction encoding as a calculation formula for performing error correction encoding on the basis of the parameters different each other for error correction encoding, a selection circuit to select one, in which a block is inputted, of the block from the plurality of error correction encoding circuit on the basis of the encoding parameters of the block for each block of an inputted signal in the error correcting encoder, a multiplexing circuit to output a plurality signals, that is arrived from the plurality of error correction encoding circuit, outputted from the error correcting encoder by multiplexing in a single signal them.

The invention according to claim5, is characterized in that the error correcting encoder according to claim 4, further comprising a delay circuit to add delay to an input signal from the error correction decoding circuit, wherein in the delay circuit a delaying amount is adjusted to be output a signal inputted to the respective error correction decoding circuit from the error correction decoding circuit after the identical time, and the multiplexing circuit outputs a multiplexed signal in the same order as that of a block inputted in the error correction encoding circuit.

The invention according to claim6, is characterized in that the error correcting encoder according to claim 6, comprising: a plurality of the first memory means to store temporality a signal outputted from plurality of an error correction encoding circuit, the second memory means for storing an any one of error correction encoding circuits, to which the block of signals inputted to the error correction encoder has been inputted, a reading means to read a signal subjected to error correcting encoding from the plurality of the first memory means on the basis of memory stored in the second memory means in the same order as that of the block of the inputted signals inputted to the error correction encoder, wherein the multiplexing circuit outputs outputted signals from the plurality of the first memory means through multiplexing in a single signal them.

According to the error correcting decoder in the invention of the first claim, a signal arrived with a mixture of error correction encoding blocks of various encoding parameters is processed for error correction decoding by inputting respective error correction encoding blocks into an appropriate error correction decoding circuit.

According to the error correcting decoder in the invention of the second claim, in the case that time for error correction decoding processing in respective error correction decoding circuits differs between respective decoding circuit, an output keeping correctly the order of encoding blocks can be yielded by adjusting the delay amount of the respective delay means to output a signal inputted in respective error correction decoding circuit after the identical time

According to the error correcting decoder in the invention of the third claim, in the case that time for error correction decoding processing in respective error correction decoding circuit differs between respective decoding circuit, the length of the block length of error correction encoding and the error correction decoding circuit, in which error correction encoding blocks have been inputted, are stored. On the basis of the memory, it is made possible that reading the data block subjected to error correction decoding in a correct order from the respective buffer memories to output.

The error correcting encoders in the invention according to in the claim 4, claim 5, and claim 6 make possible encoding by inputting respective error correction encoding blocks into an appropriate error correction encoding circuit in the case of inputting of a signal to be subjected to error correction encoding with different encoding parameters, according to similar operation to that of the error correction decoder in the invention of the claim 1, claim 2, and claim 3, respectively.

Brief Description of the Drawings:

Fig. 1 is an example of constitution of the embodiment of the claimed invention according to the first claim of the present invention;
Fig. 2 is a real example of the circuit of an input selection circuit 200;
Fig. 3 is a real example of the circuit of an output selection circuit 250;
Fig. 4 is an example of constitution of the embodiment of the claimed invention according to the second claim of the present invention; and
Fig. 5 is an example of constitution of the embodiment of the claimed invention according to the third claim of the present invention.

Detailed Description of the Preferred Embodiments:

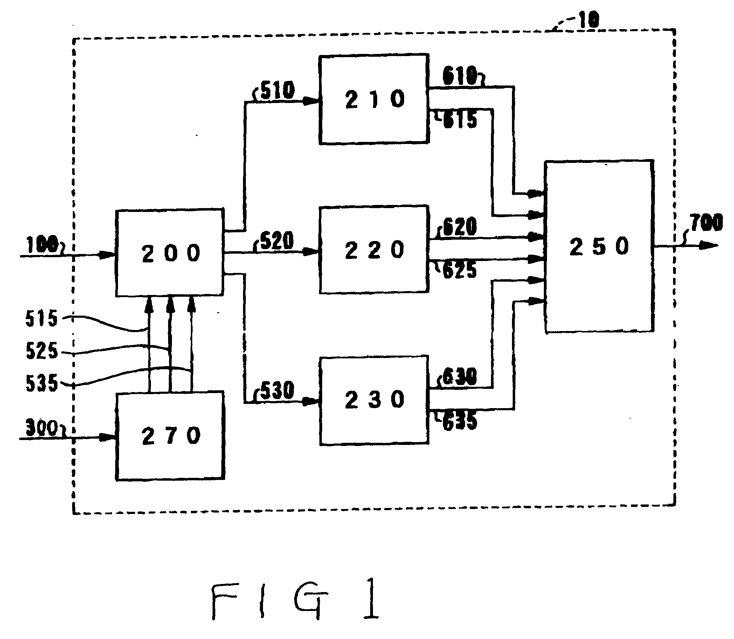

Now, referring to Figs. 1 through 5, description will proceed to first through third embodiments of the present invention.

Fig. 1 is a block diagram showing an example of constitution of the first embodiment of the present invention. The error correcting decoder 10 of the present invention is constituted by an input selection circuit 200 to divide destination of a signal and a plurality of the error correction decoding circuit 210, 220 and 230, and output selection circuit 250 to select the outputs of the error correction decoding circuit 210, 220 and 230, an input selection circuit 200, and a control circuit 270 to control the operation of the multiplexing circuit 250.

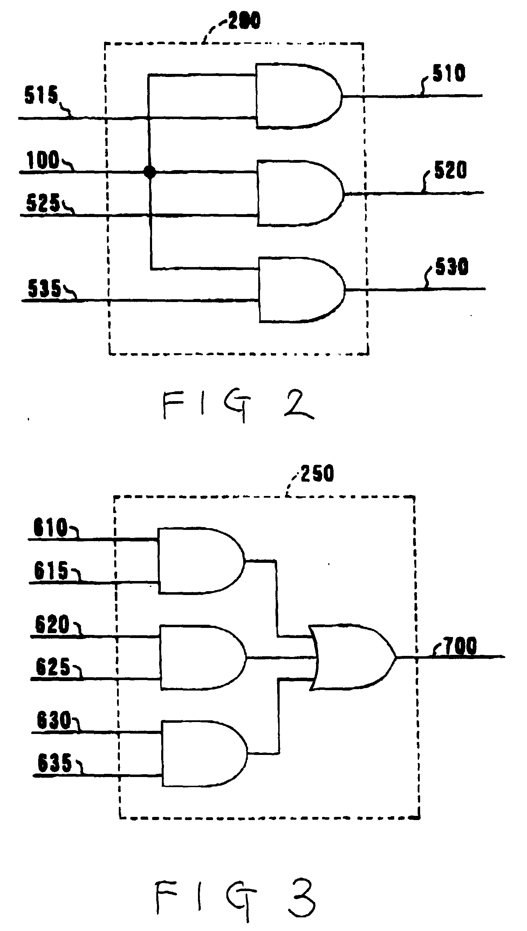

As the error correction decoding circuit 210, 220 and 230, specifically, existing error correction decoding circuits can be used. The selection circuit 200 is, specifically, realized by a gate circuit shown in Fig. 2 and outputs the input signal 100 for ones among signals 510, 520 and 530 of which control signals 515, 525 and 525 have become active. Among control signals 515, 525 and 525, two or more signals do not become active simultaneously. The output selection circuit 250 is, specifically, realized by a gate circuit, namely a selector, shown in Fig. 3 and outputs by selecting a signal to make a pair with activated ones among the control signals 615, 625 and 635 among signals 610, 620 and 630 as an output signal 700.

The following is an operation of the first embodiment of the present invention. The blocks 110, 120 and 130 (not illustrated), that is inputted in order as an input signal 100 for error correction encoding, should be subjected to error correction encoding with respective different encoding parameters. Encoding parameter means a combination of the block length of error correction encoding, or the length of redundant code, or a calculation formula for performing error correction encoding. It is assumed that encoding parameter of the block 110 is p1, encoding parameter of block 120 is p2, and encoding parameter of block 130 is p3. In correspondence with this, encoding parameters different each other are previously set such that the encoding parameter p1 is for the error correction decoding circuit 210 and the encoding parameter p2 is for decoding function 220.

Subsequently, the determined time of input of the blocks 110, 120 and 130 to be subjected to error correction encoding and information 300 showing encoding parameters of the corresponding error correction encoding blocks are inputted in a switching control function 270. The switching control function 270 generates control signals 515, 525 and 535 at the determined time of input of the blocks 110, 120 and 130 on the basis of information 300. The input selection circuit 200 switches a path for sending the blocks 110, 120 and 130 to the error correction decoding circuit according to the control signals 515, 525 and 535.

During the period in which the block 110 encoded with the encoding parameter p1, for example, is being inputted, the signal 510 is sent to the error correction decoding circuit 210. If encoding block 120 encoded with the encoding parameter p2 is subsequently inputted, a selected signal is switched from the signal 510 to the signal 520 in a boundary between blocks 110 and 120. This is sent to the error correction decoding circuit 220. By such operation, when blocks of different encoding parameters arrive continually, the error correction decoding can be carried out by inputting a signal in the error correction decoding function corresponding to an appropriate encoding parameter.

Control signals 615, 625 and 635 of data enable showing an effective portion of data with synchronization with decoded signals 610, 620 and 630 are outputted from the error correction decoding circuit 210, 220 and 230. In the output selection circuit 250, one of signals 610, 620 and 630 are selected to output the block 710 (not illustrated) decoded for inputted block 110, the block 720 (not illustrated) decoded for inputted block 120, and the block 730 (not illustrated) decoded for inputted block 130 as an output signal 700 according to these data enable signals 615, 625 and 635 in this order.

In this case, data enable signals 615, 625 and 635 attach to outputted signals 610, 620 and 630 and the output signal is selected according to data enable signals. Unless the data enable signals are not outputted, when the error correction decoding circuit is used for the error correction decoding circuit 210, 220 and 230, control signals 615, 625 and 635 compatible with data enable may be generated by the control circuit 270 with the same timing as that of aforementioned.

If the error correction decoding circuit 210, 220 and 230 are capable of change encoding parameters to process, decoding processing can be performed by a small number of the error correction decoding function. Specifically, these error corrections decoding function 210, 220 and 230 can change encoding parameters a time zone restricted to that without data under processing inside. Thus, after the time in which the error correction decoding circuit 210 finishes the decoding processing of the block 110 to complete outputting of the block 710 decoded, setting of the error correction decoding circuit 210 is changed in accordance with encoding parameters of the block 130 determined as to arrive. After completion of setting change, the input selection circuit 200 is controlled to select the signal 510 for performing decoding of the block 130 arrived. By repeating the same operation, even in the case of the encoding parameters capable of being many different values, decoding processing can be performed by a limited number of the error correction decoding function.

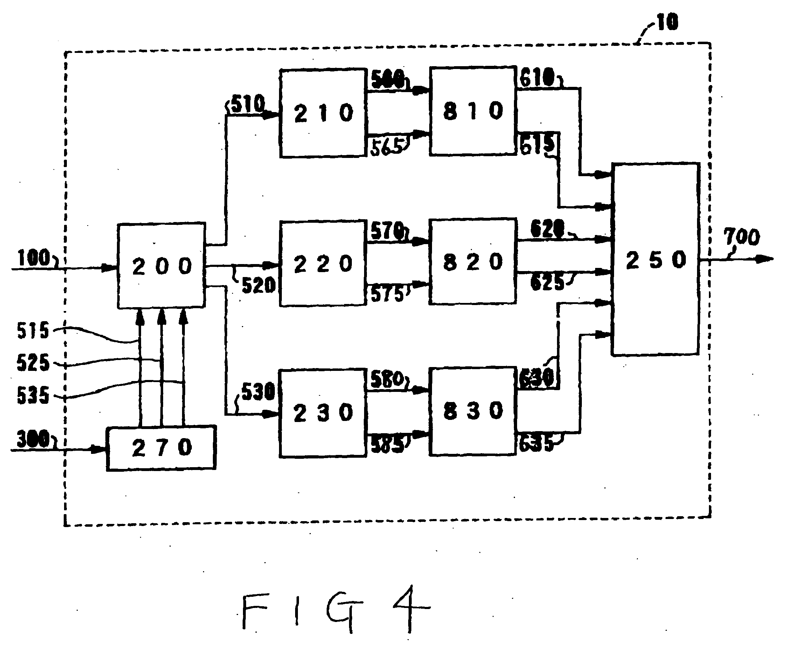

Fig. 4 is a block diagram showing an example of constitution of the second embodiment of the present invention. In addition to the first embodiment of the present invention, the second embodiment has delay circuits 810, 820 and 830 to delay an output signal of the error correction decoding circuit 210, 220 and 230. In the blocks 110, 120 and 130, blocks subjected to error correction encoding with different encoding parameters have been mixed. In this case, it is assumed that encoding parameter of the block 110 is p1, encoding parameter of block 120 is p2, and encoding parameter of block 130 is p3.

Error correction encoding parameters different each other are previously set such that the encoding parameter p1 is for the error correction decoding circuit 210 and the encoding parameter p2 is for decoding function 220. Time required for decoding processing of respective blocks may be differ each other according to the encoding parameter. In addition, delay amounts d1, d2, and d3 designated by respective delay circuits 810, 820 and 830 are set such that the sum of delay amounts of respective delay circuits and a pair of error correction decoding circuit is evenly set to make t0 value. For example, if it is assumed that processing delay amounts in error correction decoding circuit 210, 220 and 230 making a pair with respective delay means are t1, t2, t3, respectively, setting is made to hold the following equations.

$$t1+d1=t0$$

$$t2+d2=t0$$

$$t3+d3=t0$$

Subsequently, the determined time of input of the blocks 110, 120 and 130 to be subjected to error correction encoding, encoding parameters of the corresponding error correction encoding blocks, and information 300 showing length of data determined as to be inputted are inputted in the control circuit 270. The control circuit 270 generates control signals 515, 525 and 535 at the determined time of input of the blocks 110, 120 and 130 on the basis of information 300. The input selection circuit 200 switches a path for sending inputted signals to the error correction decoding circuit according to the control signals 515, 525 and 535.

During the period in which the block 110 encoded with the encoding parameter p1, for example, is being inputted, the signal 510 is sent to the error correction decoding circuit 210. If encoding block 120 encoded with the encoding parameter p2 is subsequently inputted, the inputted signal is switched from 510 to 520 in a boundary between blocks 110 and 120. Thus, a signal is inputted in the error correction decoding circuit 210, 220 and 230 by similar manner as that of the first mode of carrying out the invention. The signals 560, 570 and 580 from the error correction decoding circuit 210, 220 and 230 are inputted in the delay circuits 810, 820 and 830, respectively.

Signals 610, 620 and 630 from the delay circuits 810, 820 and 830 are outputted after compiling into a single signal 700 in the selection circuit 250. If data enable signals 565, 575 and 585 showing effective portions of outputted data are outputted from the error correction decoding circuit 210, 220 and 230 in parallel with data 560, 570 and 580, data path can be selected by using signals 615, 625 and 635 generated by delaying of data enable signals 565, 575 and 585 in the delay circuits 810, 820 and 830. This means that the block 710 (not illustrated) decoded for inputted block 110, the block 720 (not illustrated) decoded for inputted block 120, and the block 730 (not illustrated) decoded for inputted block 130 are outputted in this order using the output data from the delay circuit as an output signal 700 restricted to a period in which effective data are being inputted.

In aforementioned description, it is stated that selection of input in the output selection circuit is carried out by using signals 615, 625 and 635 showing effective portions of the data. However, it may be possible to generate a control signal separately by using information necessary and sufficiently for selection of an output signal path with a suitable timing. For instance, using information designating the error correction decoding function determined as to be used, information showing time determined as respective encoding blocks are inputted and data length determined as to be inputted, a flag showing arrival of a signal in a determined time schedule, and information of a delay time occurred in respective paths allows generating a signal for selection of a signal path.

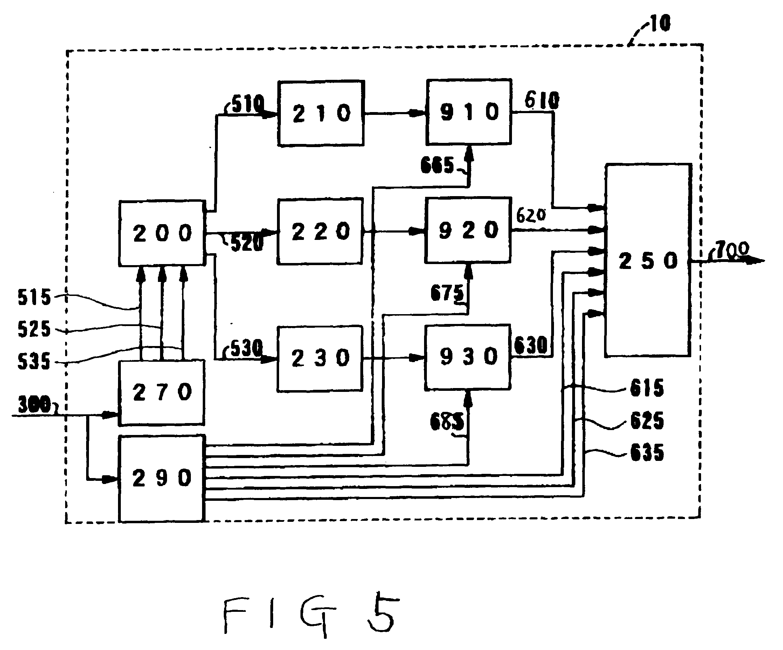

Fig. 5 is a block diagram showing an example of constitution of the third embodiment of the present invention. In addition to the first embodiment of the present invention, the third embodiment has buffer memories 910, 920 and 930 to store temporarily the outputs of the error correction decoding circuit 210, 220 and 230 and a control signal generating circuit 290 to generate control signal for reading from the buffer memories. The buffer memories 910, 920, and 930 are specifically, realized by using FIFO memory. The blocks 110, 120 and 130 inputted to be subjected to error correction encoding have mixtures of blocks subjected to error correction encoding with different encoding parameters. Herewith, it is assumed that encoding parameter of the block 110 is p1, encoding parameter of block 120 is p2, and encoding parameter of block 130 is p3.

Error encoding parameters different each other are previously set such that the encoding parameter p1 is for the error correction decoding circuit 210 and the encoding parameter p2 is for decoding function 220. Time that is required for decoding processing of respective encoding blocks could be changed according to encoding parameters.

Subsequently, the determined time of input of the blocks 110, 120 and 130, encoding parameters of corresponding blocks to be subjected to error correction encoding, and information 300 showing length of data determined as to be inputted are inputted in the control circuit 270. The control circuit 270 generates control signals 515, 525 and 535 at the determined time of input of the blocks 110, 120 and 130 on the basis of information 300. The input selection circuit 200 switches a path for sending inputted signals to the error correction decoding circuit according to the control signals 515, 525 and 535.

During the period in which the block 110 encoded with the encoding parameter p1, for example, is being inputted, the signal 510 is selected as a signal path through which an input signal is sent. If block 120 encoded with the encoding parameter p2 is subsequently inputted, the signal path is switched from 510 to 520 in a boundary between encoding blocks 110 and 120. Thus, a signal is inputted in the error correction decoding circuit 210, 220 and 230 by similar manner as those of the first and second modes of carrying out the invention. The output from the error correction decoding circuit 210, 220 and 230 are accumulated in the buffer memories 910, 920 and 930, respectively.

On the other hand, in the control signal generating circuit 290, signals 615, 625 and 635 showing effective portions of signals 610, 620 and 630, which are read from control signals 665, 675 and 685 to read signals from buffer memories 910, 920 and 930 and the buffer memories, are generated with an appropriate timing on the basis of information showing length of the block 110, 120 and 130 inputted and timing of input and which error correction function used. Generated control signals 665, 675 for reading is sent to buffer memories 910, 920 and 930. As the result, signals 610, 620 and 630 read from buffer memories 910, 920 and 930 are outputted after compiling in a single output signal 700 in the output selection circuit 250.

In the above description, the following information is used: length of the block 110, 120 and 130 actually inputted in the error correction decoding circuit 210, 220 and 230 and timing of input and which error correction function used. Other information may be used if it is necessary and sufficient to read for only a necessary length from the buffer with a correct timing. For instance, using information designating the error correction decoding function determined as to be used, information showing time determined as respective encoding blocks are inputted and data length determined as to be inputted, and a flag showing arrival of a signal in a determined time schedule allows realizing a compatible function with aforementioned.

Examples of constitution of the error correcting decoder as the first to third embodiments of the present invention have been described herewith. Replacing the error correcting decoding circuit to the error correcting encoding circuit in the same constitution allows realizing the error correcting encoder usable for a signal in which a plurality of encoding parameters have been mixed.

The first effect of the present invention is to make possible the error correcting encoding or the error correcting decoding of a data series, which was difficult to process by conventional error correcting encoder and the error correcting decoder, and of which encoding parameters of a encoding blocks differ from each encoding block. Where, encoding parameter means a block length of error correction encoding or a length of redundant code, or a calculation formula used for encoding processing.

In the second effect of the present invention, using error correction encoding circuit and error correction decoding circuit in which processing time for error correction encoding and error correction decoding changes according to error correcting encoding parameters allows absorption of a difference in processing time occurred during error correction encoding and error correction decoding of data series in which encoding parameters differs in respective encoding blocks in order to yield serially the result of error correction encoding and error correction decoding in the correct order..

**Claims**

1. An error correcting decoder for decoding with correcting an error of a datum subjected to error correction encoding in a block unit comprising:

   a plurality of an error correction decoding circuit for performing error correction decoding processing for a block length of error correction encoding, or a length of redundant code, or such parameter for error correction encoding of a calculation formula for performing error correction encoding on the basis of said parameters different each other for error correction encoding,
   a selection circuit for selecting one, in which a block is inputted, of said blocks from said plurality of error correction decoding circuit on the basis of the encoding parameters of the block for each block of an inputted signal in said error correcting decoder,
   a multiplexing circuit for outputting a plurality of output signals, that is arrived from said plurality of error correction decoding circuit, from said error correcting decoder by multiplexing in a single signal them.

2. The error correcting decoder according to claim 1, further comprising:

   a delay circuit for adding delay to an output signal arrived from said error correction decoding circuit or an input signal to said respective error correction decoding circuit, wherein
   in said delay circuit, a delaying amount is adjusted to be output a signal inputted to said respective error correction decoding circuit from said error correction decoding circuit after the identical time, and

said multiplexing circuit outputs a multiplexed signal in the same order as that of a block inputted to said error correction decoding circuit.

**3.** The error correcting decoder according to claim 1, further comprising:

a plurality of the first memory means for storing temporality a signal outputted from plurality of an error correction decoding circuit,

the second memory means for storing an one of error correction decoding circuits, to which said block of signals inputted to the error correction decoder has been inputted,

a reading means for reading a signal subjected to error correcting decoding from said plurality of the first memory means on the basis of memory stored in said second memory means in the same order as that of the block of the input signals inputted to said error correction decoder,

wherein said multiplexing circuit outputs outputted signals from said plurality of the first memory means through multiplexing in a single signal.

**4.** An error correcting encoder for performing error correcting encoding for each block unit of a digital datum comprising:

a plurality of an error correction encoding circuit for performing error correction encoding processing for a block length of error correction encoding, or a length of redundant code, or such parameter for error correction encoding as a calculation formula for performing error correction encoding on the basis of said parameters different each other for error correction encoding,

a selection circuit for selecting one, to which a block is inputted, of said block from said plurality of error correction encoding circuit on the basis of the encoding parameters of the block for each block of an inputted signal to said error correcting decoder,

a multiplexing circuit for outputting a plurality of output signals, that is arrived from said plurality of error correction encoding circuit, outputted from said error correcting encoder by multiplexing in a single signal them.

**5.** The error correcting encoder according to claim 4, further comprising:

a delay circuit for adding delay to an input signal from said error correction decoding circuit, wherein

in said delay circuit, a delaying amount is adjusted to be output a signal inputted to said respective error correction decoding circuit from said error correction decoding circuit after the identical time, and

said multiplexing circuit outputs a multiplexed signal in the same order as that of a block inputted to said error correction encoding circuit.

**6.** The error correcting encoder according to claim 4, further comprising:

a plurality of first memory means for storing temporality a signal outputted from said plurality of error correction encoding circuits,

the second memory means for storing any one of error correction encoding circuits, to which said block of signals inputted to the error correction encoder has been inputted,

a reading means for reading a signal subjected to error correcting encoding from said plurality of first memory means on the basis of memory stored in the second memory means in the same order as that of the block of the inputted signals inputted to said error correction encoder, wherein

said multiplexing circuit outputs outputted signals from said plurality of first memory means through multiplexing in a single signal them.

FIG 1

EP 1 017 179 A2

FIG 2

FIG 3

9

F I G 4

FIG 5

EP 1 017 179 A2